# EUROPEAN PATENT APPLICATION

(11) **EP 4 835 873 A1**
(43) Date of publication of application: **04.11.2026**
(21) Application number: 26173550.0
(22) Date of filing: 21.04.2026
(51) Int. Cl.: G09G 3/20, G09G 5/10

(54) **LUMINANCE COMPENSATION DEVICE, METHOD, AND DISPLAY DEVICE**

(30) Priority: 29.04.2025 KR 20250056706
(71) Applicant: LX Semicon Co., Ltd., Daejeon 34027 (KR)
(72) Inventor: SHIN, Hyeonwoon, 34027 Daejeon (KR); MOON, Kwihyeon, 34027 Daejeon (KR); HONG, Changsung, 34027 Daejeon (KR); LIM, Homin, 34027 Daejeon (KR)
(74) Representative: Goddar, Heinz J.

(57) **Abstract**

A luminance compensation device may include a panel current prediction device configured to obtain an interval average value of current APL based on image data provided to a panel and obtain a predicted panel current based on a maximum panel current and the interval average value of current APL, a current sensor connected to a power line on the panel and configured to sense an actual panel current, and a luminance compensation unit configured to obtain luminance compensation information by comparing the predicted panel current with the actual panel current and adjust the image data based on the luminance compensation information to obtain compensated image data.

## Description

### CROSS-REFERENCE TO RELATED APPLICATIONS

This application claims the priority of Korean Patent Application No. 10-2025-0056706, filed on April 29, 2025.

### BACKGROUND

### Field of the Disclosure

The present disclosure relates to a luminance compensation device, a method, and a display device.

### Discussion of the Related Art

Recently, interest in display devices used in mobile phones, flat panel TVs, MP3s, and the like has explosively increased. The display devices include a liquid crystal display (LCD), an organic light-emitting display device, and the like.

A panel provided in the display device includes a plurality of pixels, and displays an image by individually emitting light from the plurality of pixels.

A current flowing in the panel, that is, a panel current, varies according to temperature. For example, when a temperature of the panel increases, a carrier mobility of a thin film transistor on the panel increases or a threshold voltage decreases.

Accordingly, more current flows in each pixel, thereby increasing the panel current. As the panel current increases, luminance also increases.

There is a problem in that power consumption increases as the panel current increases.

In addition, there is a problem in that a lifespan of the panel is reduced in the long term as the panel current increases.

Further, there is a problem in that distortion of image data occurs due to luminance higher than a desired luminance, thereby causing image quality deterioration.

### SUMMARY

The present disclosure is to solve the above-described problems and other problems.

Accordingly, the present disclosure provides a luminance compensation device, a method, and a display device capable of reducing power consumption.

In addition, the present disclosure provides a luminance compensation device, a method, and a display device capable of increasing a lifespan.

In addition, the present disclosure provides a luminance compensation device, a method, and a display device capable of improving image quality.

The present disclosure is not limited to those described, and includes those that can be understood through the description of the disclosure.

In order to achieve the above or other objects, according to one aspect, a luminance compensation device comprises a panel current prediction device configured to obtain an interval average value of current APL based on image data provided to a panel, and obtain a predicted panel current based on a maximum panel current and the obtained interval average value of current APL; a current sensor connected to a power line on the panel and configured to sense an actual panel current; and a luminance compensation unit configured to obtain luminance compensation information by comparing the obtained predicted panel current with the sensed actual panel current, and adjust the image data based on the obtained luminance compensation information to obtain compensated image data.

The interval average value of current APL may be an average value obtained for frames within a first interval, and the actual panel current may be an average value of panel currents obtained for frames within a second interval.

When the interval average value of current APL has a normalized value between 0 and 100 and the current APL has a normalized value of 100 corresponding to the maximum panel current, the predicted panel current may be the interval average value of current APL.

The current sensor may comprise a shunt resistor connected to the power line and configured to generate a voltage difference; and a current sensing circuit configured to obtain the actual panel current based on the voltage difference.

The luminance compensation unit may obtain a gain value as the luminance compensation information using the actual panel current and the predicted panel current when the actual panel current is greater than the predicted panel current.

The gain value may be a ratio of the predicted panel current to the actual panel current.

The gain value may have a plurality of levels that decrease stepwise based on 1 during a predetermined time.

The luminance compensation unit may obtain the compensated image data by multiplying the gain value by each of data signals of all subpixels of the image data.

The panel current prediction device may obtain a panel current line using the maximum panel current, and the panel current line may be linear or non-linear.

In order to achieve the above or other objects, according to another aspect, a luminance compensation method comprises obtaining an interval average value of current APL based on image data provided to a panel; obtaining a predicted panel current based on a maximum panel current and the obtained interval average value of current APL; sensing an actual panel current by being connected to a power line on the panel; obtaining luminance compensation information by comparing the obtained predicted panel current with the sensed actual panel current; and adjusting the image data based on the obtained luminance compensation information to obtain compensated image data.

The obtaining of the luminance compensation information may comprise obtaining a gain value as the luminance compensation information using the actual panel current and the predicted panel current when the actual panel current is greater than the predicted panel current.

The obtaining of the compensated image data may comprise multiplying the gain value by each of all subpixels of the image data to obtain the compensated image data.

In order to achieve the above or other objects, according to still another aspect, a display device comprises a panel; a panel driving device configured to drive the panel; and a luminance compensation device configured to compensate luminance of the panel, wherein the luminance compensation device comprises a panel current prediction device configured to obtain an interval average value of current APL based on image data provided to the panel, and obtain a predicted panel current based on a maximum panel current and the interval average value of current APL; a current sensor connected to a power line on the panel and configured to sense an actual panel current; and a luminance compensation unit configured to obtain luminance compensation information by comparing the obtained predicted panel current with the sensed actual panel current, and adjust the image data based on the obtained luminance compensation information to obtain compensated image data.
The luminance compensation device and/or the display device may comprise any one, some or all of the features disclosed herein with respect to the luminance compensation method, unless indicated otherwise or technically inappropriate. The luminance compensation method may comprise any one, some or all of the features disclosed herein with respect to the luminance compensation device and/or the display device, unless indicated otherwise or technically inappropriate.

Effects of the luminance compensation device, method, and display device according to the above aspects will be described as follows.

According to at least one of the above aspects, since luminance of an entire panel is reduced by the gain value, the actual panel current can be also reduced, thereby reducing power consumption.

According to at least one of the above aspects, when a temperature of the panel exceeds a threshold, the actual panel current can be reduced through luminance adjustment, thereby improving a lifespan in the long term.

According to at least one of the above aspects, when temperature increases, luminance higher than a target luminance can be reduced to the target luminance, thereby preventing data distortion and improving image quality.

### BRIEF DESCRIPTION OF THE DRAWINGS

The accompanying drawings are included to provide further understanding of the present disclosure, and are incorporated in and constitute a part of the present disclosure. The accompanying drawings illustrate aspects of the present disclosure and together with the description serve to explain principles of the present disclosure.

In the drawings:
FIG. 1 is a block diagram illustrating a display device according to the present disclosure.
FIG. 2 is a block diagram illustrating a luminance compensation device according to the present disclosure.
FIG. 3 illustrates the luminance compensation device of FIG. 2 in detail.
FIG. 4 shows an average value of current average picture level (APL).
FIG. 5 shows an actual panel current.
FIG. 6 shows luminance compensation using a predicted panel current and an actual panel current.
FIG. 7 shows an example of application of a gain value.
FIG. 8 shows various panel current lines.

Sizes, shapes, numerical values, and the like of components illustrated in the drawings may be different from actual ones. Further, even when the same components are illustrated with different sizes, shapes, numerical values, and the like in the drawings, this is only an example in the drawings, and the same components may have the same sizes, shapes, numerical values, and the like across the drawings.

### DETAILED DESCRIPTION

Hereinafter, the aspects disclosed in the present specification will be described in detail with reference to the accompanying drawings, and the same or similar components are assigned the same reference numerals regardless of reference numerals, and redundant descriptions thereof will be omitted. In the following description, suffixes "module" and "unit" for components used in the present specification are given or mixed in consideration of convenience of description of the specification, and do not have meanings or roles distinguished from each other by themselves. In addition, the accompanying drawings are provided to easily understand the aspects disclosed in the present specification, and the technical idea disclosed in the present specification is not limited by the accompanying drawings. In addition, when an element such as a layer, region, or substrate is referred to as being on another element, it includes not only being directly on the other element but also being on the other element with another intermediate element therebetween.

Hereinafter, "~module", "~unit", "~device", and the like may be configured as a "~circuit" or an "integrated circuit". "~module", "~unit", "~device", and the like may be used interchangeably with "~circuit" or "integrated circuit".

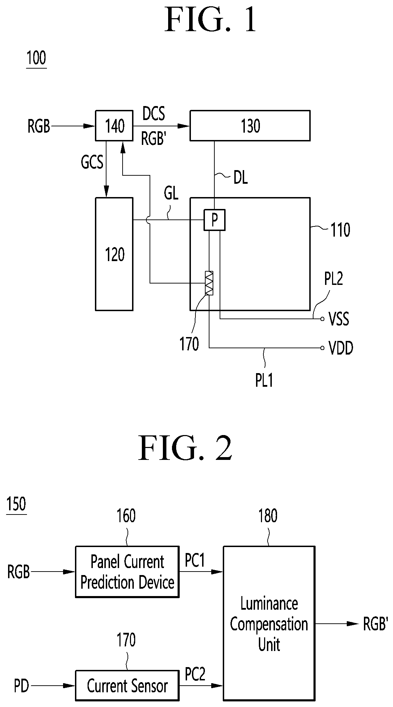

FIG. 1 is a block diagram illustrating a display device according to the present disclosure.

Referring to FIG. 1, a display device 100 according to the present disclosure may include a panel 110, a data processing device 140, and panel driving devices 120 and 130.

In the present disclosure, the panel 110 may be a liquid crystal panel, an organic light-emitting panel, or a micro LED-based panel, but is not limited thereto. A plurality of data lines DL and a plurality of gate lines GL may be disposed in the panel 110. A plurality of pixels P may be disposed at intersections of the plurality of data lines DL and the plurality of gate lines GL. The plurality of pixels P may be arranged in a matrix.

The pixel P may be a minimum unit for displaying an image. In order to display the image, the pixel P may include a plurality of subpixels for displaying a plurality of colors. For example, the pixel P may include a red subpixel displaying a red color, a green subpixel displaying a green color, and a blue subpixel displaying a blue color, but is not limited thereto.

The panel driving devices 120 and 130 may drive the panel 110. The panel driving devices may include a gate driving device 120, a data driving device 130, and a data processing device 140. The panel driving devices 120 and 130 may include more components than these.

The gate driving device 120 may supply a scan signal having a turn-on voltage or a turn-off voltage to the gate line GL. For example, the turn-on voltage may have a high level, and the turn-off voltage may have a low level, but is not limited thereto. For example, each subpixel may be connected to the data line DL in response to the scan signal of the turn-on voltage so that an image corresponding to a data voltage, that is, a grayscale voltage, may be displayed. For example, each subpixel may be disconnected from the data line DL in response to the scan signal of the turn-off voltage, so that an image is not displayed.

The gate driving device 120 may include at least one gate driving circuit. The gate driving circuit may include a gate driver IC.

The data driving device 130 may generate a data voltage and supply the data voltage to the data line DL. As described above, when the data line DL is connected to each subpixel by the scan signal, the data voltage may be supplied to each subpixel.

The data driving device 130 may convert compensated image data RGB' provided from the data processing device 140 into a data voltage using a gamma voltage provided from a gamma voltage circuit. Here, the compensated image data RGB' may be image data whose luminance is adjusted to reduce a panel current increased according to an increase in temperature.

The data processing device 140 may supply various control signals GCS and DCS to the gate driving device 120 and the data driving device 130. For example, the data processing device 140 may generate a gate control signal GCS for starting scanning according to a timing implemented in each frame and transmit the gate control signal to the gate driving device 120. The data processing device 140 may obtain the compensated image data RGB' by adjusting luminance of image data RGB input from an external device in consideration of the actual panel current PC2. The data processing device 140 may transmit a data control signal DCS for controlling the data driving device 130 to supply the data voltage to each subpixel according to each timing.

The data processing device 140 may be referred to as a timing controller. The data processing device 140 and the panel driving devices 120 and 130 may be integrated into a single IC, but are not limited thereto.

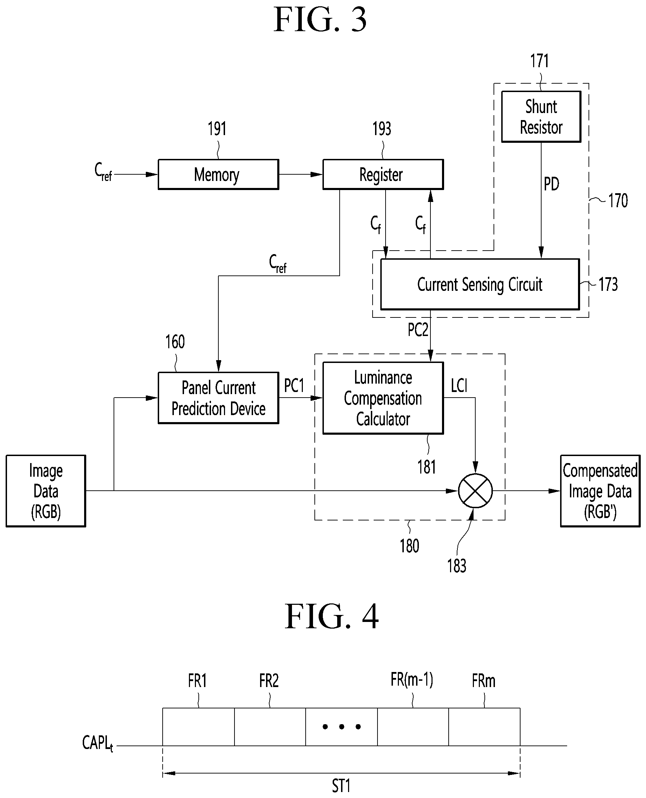

FIG. 2 is a block diagram illustrating a luminance compensation device according to the present disclosure. FIG. 3 illustrates the luminance compensation device of FIG. 2 in detail.

Referring to FIGS. 1 to 3, a luminance compensation device 150 according to the present disclosure may include a panel current prediction device 160, a current sensor 170, and a luminance compensation unit 180.

The luminance compensation device 150 may be included in the data processing device 140, but is not limited thereto.

The panel current prediction device 160 may predict a panel current. That is, the panel current prediction device 160 may obtain an interval average value of current average picture level (APL) based on image data RGB provided to the panel 110, and obtain a predicted panel current PC1 based on a maximum panel current Cref and the obtained interval average value of current APL.

The image data RGB of one frame may include data signals of a plurality of subpixels included in a plurality of pixels P on the panel 110. Here, the data signals may be composed of digital bits and may have predetermined grayscale values. Light having luminance corresponding to the data signal may be generated from the corresponding subpixel. In this way, an image may be displayed by generating light having different luminance from each of the plurality of subpixels on the panel 110 for each frame.

The current APL may be defined as real-time current consumption corresponding to an APL of the panel 110 currently being output. That is, the current APL may be an index indicating how much current is consumed in the panel 110 at a current average brightness level on the panel 110. The current APL may be used to quantitatively analyze or predict power consumption.

A method of obtaining the interval average value CAPLt of current APL will be described.

First, a current APL of one pixel P may be calculated using Equation 1. [Equation 1] $CAPLp = xR + yG + zB$

Here, CAPLp is a current APL of one pixel P, x, y, and z are current ratios of R, G, and B, respectively, and R, G, and B may be a red data signal, a green data signal, and a blue data signal constituting one pixel P included in the image data RGB.

The current ratios of R, G, and B may be predetermined. For example, when R = G = B = 255, it may be assumed that a current ratio of R:G:B is 1:1:2. In this case, the current APL CAPLp of one pixel P may be (0.25R + 0.25G + 0.5B).

Using Equation 1, the current APL of each of all pixels P included in the image data RGB may be calculated.

Thereafter, an average value of current APL of one frame may be calculated. The average value of current APL of one frame may be calculated by averaging the current APLs of all pixels P calculated as described above. The average value of current APL of one frame may be represented by Equation 2. [Equation 2] $CAPLf = \left[SUM\left(xR+yG+zB\right)/total number of pixels P\right] \times 100$

Here, CAPLf is the average value of current APL of one frame, and SUM(xR + yG + zB) may be a sum of current APLs of all pixels P.

As shown in FIG. 4, an average value of current APL may be calculated for each of frames FR1 to FRm included in a first interval ST1.

In this case, the interval average value CAPLt of current APL may be calculated by averaging the average values of current APL calculated for the frames FR1 to FRm included in the first interval ST1. In this way, the interval average value CAPLt of current APL may be continuously obtained for each number of frames FR1 to FRm included in the first interval ST1.

Meanwhile, the current sensor 170 may sense an actual current flowing in the panel 110, that is, an actual panel current PC2. The current sensor 170 may include a shunt resistor 171 and a current sensing circuit 173.

The shunt resistor 171 may be connected to a first power line PL1 as shown in FIG. 1, but may also be connected to a second power line PL2. The shunt resistor 171 may be mounted on a substrate as a component or formed on a substrate through a semiconductor process.

A first power line PL1 and a second power line PL2 may be connected to all pixels P (or subpixels) provided on the panel 110. A high potential voltage VDD may be supplied to all pixels P on the panel 110 through the first power line PL1, and a low potential voltage VSS may be supplied to all pixels P through the second power line PL2. Each pixel P (or subpixel) may generate light having a predetermined luminance using the high potential voltage VDD and the low potential voltage VSS.

By connecting the shunt resistor 171 to the first power line PL1, a voltage difference PD may be generated across the shunt resistor 171 due to a resistance of the shunt resistor 171. For example, when the panel 110 is driven, current may flow in the first power line PL1 by the high potential voltage VDD. The voltage difference PD may be generated by the shunt resistor 171 due to the current.

The current sensing circuit 173 may obtain the actual panel current PC2 using the voltage difference PD and the resistance of the shunt resistor 171.

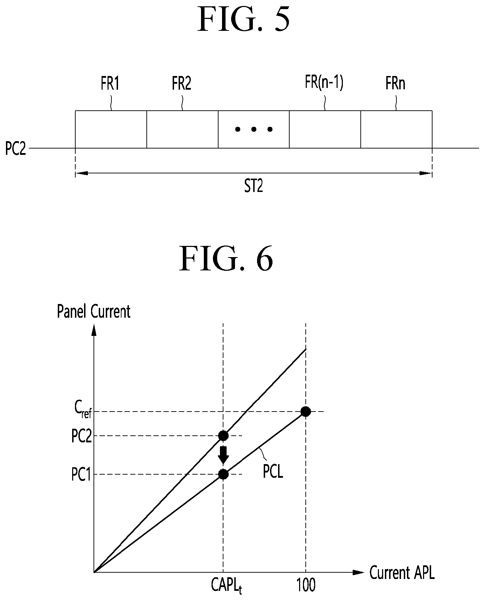

In the present disclosure, the actual panel current PC2 may be an average value of panel currents obtained for frames FR1 to FRn within a second interval ST2 shown in FIG. 5. The number of frames FR1 to FRn included in the second interval ST2 may be the same as or different from the number of frames FR1 to FRm included in the first interval ST1.

As shown in FIG. 3, the current sensing circuit 173 may obtain the panel current for each frame. The panel current obtained for each frame may be stored in a register 193.

The current sensing circuit 173 may average the panel currents obtained for each frame. The current sensing circuit 173 may retrieve the panel currents stored in the register 193 in real time and average the panel currents. When the panel currents are averaged for the number of frames corresponding to the second interval ST2 shown in FIG. 5, the averaged value may be obtained as the actual panel current PC2. In this manner, the actual panel current PC2 may be continuously obtained for each number of frames corresponding to the second interval ST2.

Meanwhile, the luminance compensation unit 180 may adjust luminance of image data RGB using the predicted panel current PC1 provided from the panel current prediction device 160 and the actual panel current PC2 provided from the current sensor 170. The luminance compensation unit 180 may obtain luminance compensation information LCI by comparing the predicted panel current PC1 and the actual panel current PC2, and adjust the image data RGB based on the luminance compensation information LCI to obtain compensated image data RGB'.

For example, data signals of all subpixels constituting the image data RGB may be uniformly adjusted in luminance. For example, when the actual panel current PC2 is greater than the predicted panel current PC1, luminance may be adjusted such that the data signals of all subpixels constituting the image data RGB are uniformly reduced.

That the actual panel current PC2 is greater than the predicted panel current PC1 may mean that a temperature of the panel 110 is higher than a threshold. In this case, luminance of the image data RGB may be reduced so that the temperature of the panel 110 decreases. When the luminance of the image data RGB is reduced, the panel current is reduced, and this may lead to a decrease in the temperature of the panel 110.

In the present disclosure, the memory 191 is a non-volatile flash memory and the register 193 may be volatile, but is not limited thereto. Accordingly, when power is turned off, data or information in the register 193 may be lost. In contrast, the memory 191 may retain data or information even when power is turned on or off.

As shown in FIG. 3, the maximum panel current Cref may be obtained in a mass production process stage of a product and stored in the memory 191. When power is turned on and the panel 110 is driven, the maximum panel current Cref stored in the memory 191 may be stored in the register 193.

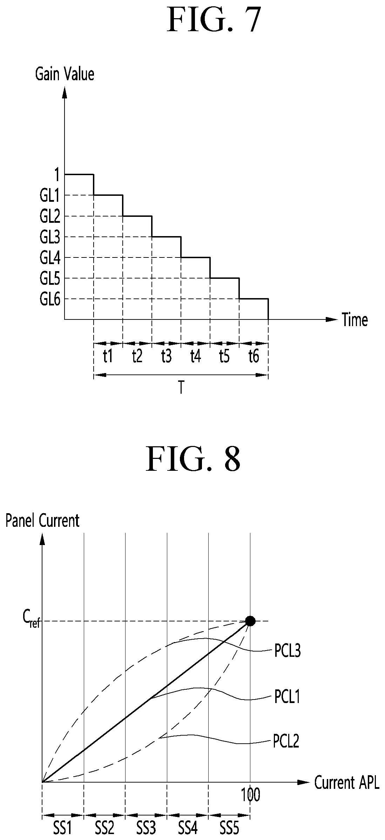

The panel current prediction device 160 may obtain a panel current line PCL using the maximum panel current Cref. In the present disclosure, description is made limited to a linear panel current line PCL as shown in FIG. 6, but as shown in FIG. 8, not only a first panel current line PCL1, which is linear, but also a second panel current line PCL2 or a third panel current line PCL3, which is non-linear, may be applied. The panel current prediction device 160 may obtain one of the first to third panel current lines PCL1 to PCL3 shown in FIG. 8 using the maximum panel current Cref.

The current APL may be divided into a plurality of sections SS1 to SS5, and a panel current corresponding to a value of an arbitrary current APL within each of the sections SS1 to SS5 may be estimated using interpolation, thereby obtaining the second panel current line PCL2 or the third panel current line PCL3, which is non-linear.

Alternatively, the second panel current line PCL2 or the third panel current line PCL3, which is non-linear, may be obtained using a predetermined equation based on the maximum panel current Cref.

Meanwhile, the first to third panel current lines PCL1 to PCL3 shown in FIG. 8, or one of them, may be obtained in advance during a mass production process stage of a product and stored in the memory 191. One of the first to third panel current lines PCL1 to PCL3 stored in the memory 191 may be set to an active state. In this case, although not shown in FIG. 3, the panel current prediction device 160 may retrieve the panel current line PCL set to the active state from the memory 191 instead of the maximum panel current Cref, and obtain the predicted panel current PC1 based on the panel current line PCL and the interval average value CAPLt of current APL.

FIG. 6 shows luminance compensation using a predicted panel current and an actual panel current.

As shown in FIG. 6, the interval average value CAPLt of current APL may have a normalized value between 0 and 100. In this case, it may be assumed that the current APL has a normalized value of 100 corresponding to the maximum panel current Cref.

As described above, the interval average value CAPLt of current APL may be an average value obtained for frames within one interval as shown in FIG. 4.

In this case, the predicted panel current PC1 may be calculated using Equation 3. [Equation 3] $PC 1 = \left[Cref/100\right] CAPLt$

Here, the interval average value CAPLt of current APL may have a normalized value between 0 and 100. When the maximum panel current Cref corresponds to a normalized current APL of 100, from Equation 3, the predicted panel current PC1 may be the interval average value CAPLt of current APL. In this case, when the current APL has a normalized value of 100 corresponding to the maximum panel current Cref, the predicted panel current PC1 may be the interval average value CAPLt of current APL.

The interval average value CAPLt of current APL may be positioned between 0 and 100 on a horizontal axis shown in FIG. 6. Accordingly, by matching the interval average value CAPLt of current APL to the panel current line PCL, the predicted panel current PC1 corresponding to the interval average value CAPLt of current APL may be obtained.

Referring again to FIGS. 1 to 3, the luminance compensation unit 180 may include a luminance compensation calculator 181 and a luminance adjustment unit 183.

The luminance compensation calculator 181 may obtain a gain value as luminance compensation information using the actual panel current PC2 and the predicted panel current PC1 when the actual panel current PC2 is greater than the predicted panel current PC1.

As an example, the gain value may be calculated using Equation 4. [Equation 4] $G = PC 1 / PC 2$

Here, G is the gain value, PC1 is the predicted panel current, and PC2 is the actual panel current.

Since the predicted panel current PC1 is a reference value for calculating the gain value G, it may be referred to as a reference panel current.

From Equation 4, the gain value G may be obtained using the predicted panel current PC1 and the actual panel current PC2. That is, the gain value G may be a ratio of the predicted panel current PC1 to the actual panel current PC2.

When the actual panel current PC2 is greater than the predicted panel current PC1, a gain value G less than 1 may be obtained, and when the actual panel current PC2 is less than the predicted panel current PC1, a gain value G greater than 1 may be obtained.

In the present disclosure, the gain value G less than 1 obtained when the actual panel current PC2 is greater than the predicted panel current PC1 may be used to reduce luminance of the image data RGB.

In general, when the panel 110 is driven, a temperature of the panel 110 increases, and thus a case in which the actual panel current PC2 is less than the predicted panel current PC1 may not occur. However, depending on characteristics of the panel 110, when the panel 110 is driven, the temperature of the panel 110 may decrease. In this situation, the gain value G greater than 1 obtained when the actual panel current PC2 is less than the predicted panel current PC1 may be used to reduce luminance of the image data RGB.

As another example, as shown in FIG. 7, the gain value G may have levels GL1 to GL6 that decrease stepwise based on 1 during a predetermined time T. The predetermined time T may have a plurality of sub-intervals t1 to t6, and the levels GL1 to GL6 in the first to sixth sub-intervals t1 to t6 may be different from each other. The levels GL1 to GL6 may decrease from the first interval t1 to the sixth interval t6.

For example, luminance of the image data RGB may be adjusted first with the gain value G of a first level GL1, and then luminance of the image data RGB may be adjusted with the gain value G of a second level GL2. In this manner, luminance of the image data RGB may be adjusted with the gain value G of a last level, that is, a sixth level GL6. In this way, by adjusting luminance of the image data RGB using the gain value G having levels GL1 to GL6 that decrease stepwise, luminance adjustment may be more precisely and rapidly controlled such that an overheated temperature becomes a target temperature.

Meanwhile, the luminance adjustment unit 183 may obtain the compensated image data RGB' by multiplying the gain value G by each of data signals of all subpixels of the image data RGB. Accordingly, data signals of all subpixels of the compensated image data RGB' are reduced by the gain value G, and luminance may be reduced by the gain value G. Since luminance is reduced by the gain value G in each of all subpixels, luminance of the entire panel 110 may also be reduced by the gain value G.

According to the present disclosure, since luminance of the entire panel 110 is reduced by the gain value G, the actual panel current PC2 is also reduced, and thus power consumption can be reduced.

According to the present disclosure, when the temperature of the panel 110 exceeds a threshold, a lifespan can be improved in the long term by reducing the actual panel current PC2 through luminance adjustment.

According to the present disclosure, when temperature increases, image quality can be improved by reducing luminance higher than a target luminance to the target luminance and preventing data distortion.

The above detailed description should not be construed as restrictive in all aspects and should be considered as illustrative. The scope of the above-described aspects should be determined by a reasonable interpretation of the appended claims, and all changes within an equivalent scope of the above-described aspects are included in the scope of the above-described aspects.

## Claims

1. A luminance compensation device, comprising:
a panel current prediction device configured to obtain an interval average value of current average picture level (APL) based on image data provided to a panel, and obtain a predicted panel current based on a maximum panel current and the obtained interval average value of current APL;
a current sensor connected to a power line on the panel and configured to sense an actual panel current; and
a luminance compensation unit configured to obtain luminance compensation information by comparing the obtained predicted panel current with the sensed actual panel current, and adjust the image data based on the obtained luminance compensation information to obtain compensated image data.

2. The luminance compensation device of claim 1, wherein the interval average value of current APL is an average value obtained for frames within a first interval, and the actual panel current is an average value of panel currents obtained for frames within a second interval.

3. The luminance compensation device of claim 1 or 2 , wherein, when the interval average value of current APL has a normalized value between 0 and 100 and when current APL has a normalized value of 100 corresponding to the maximum panel current, the predicted panel current is the interval average value of current APL.

4. The luminance compensation device of any one of the preceding claims, wherein the current sensor comprises:
a shunt resistor connected to the power line and configured to generate a voltage difference; and
a current sensing circuit configured to obtain the actual panel current based on the voltage difference.

5. The luminance compensation device of any one of the preceding claims, wherein the luminance compensation unit is configured to, when the actual panel current is greater than the predicted panel current, obtain a gain value as the luminance compensation information using the actual panel current and the predicted panel current.

6. The luminance compensation device of claim 5, wherein the gain value is a ratio of the predicted panel current to the actual panel current.

7. The luminance compensation device of claim 5 or 6, wherein the gain value has a plurality of levels that decrease stepwise based on 1 during a predetermined time.

8. The luminance compensation device of any one of claims 5 to 7, wherein the luminance compensation unit is configured to multiply the gain value by each of data signals of all subpixels of the image data to obtain the compensated image data.

9. The luminance compensation device of any one of the preceding claims, wherein the panel current prediction device is configured to obtain a panel current line using the maximum panel current, and the panel current line is linear or non-linear.

10. A luminance compensation method, comprising:
obtaining an interval average value of current average picture level (APL) based on image data provided to a panel;
obtaining a predicted panel current based on a maximum panel current and the obtained interval average value of current APL;
sensing, by a current sensor, an actual panel current, the current sensor being connected to a power line on the panel;
obtaining luminance compensation information by comparing the obtained predicted panel current with the sensed actual panel current; and
adjusting the image data based on the obtained luminance compensation information to obtain compensated image data.

11. The luminance compensation method of claim 10, wherein the interval average value of current APL is an average value obtained for frames within a first interval, and the actual panel current is an average value of panel currents obtained for frames within a second interval.

12. The luminance compensation method of claim 10 or 11, wherein when the interval average value of current APL has a normalized value between 0 and 100 and current APL has a normalized value of 100 corresponding to the maximum panel current, the predicted panel current is the interval average value of current APL.

13. The luminance compensation method of any one of claims 10 to 12, wherein the obtaining of the luminance compensation information comprises, when the actual panel current is greater than the predicted panel current, obtaining a gain value as the luminance compensation information using the actual panel current and the predicted panel current.

14. The luminance compensation method of claim 13, wherein the obtaining of the compensated image data comprises multiplying the gain value by each of data signals of all subpixels of the image data to obtain the compensated image data.

15. A display device, comprising:
a panel;
a panel driving device configured to drive the panel; and
a luminance compensation device configured to compensate luminance of the panel,
wherein the luminance compensation device comprises:
a panel current prediction device configured to obtain an interval average value of current average picture level (APL) based on image data provided to the panel, and obtain a predicted panel current based on a maximum panel current and the interval average value of current APL;
a current sensor connected to a power line on the panel and configured to sense an actual panel current; and
a luminance compensation unit configured to obtain luminance compensation information by comparing the obtained predicted panel current with the sensed actual panel current, and adjust the image data based on the obtained luminance compensation information to obtain compensated image data.
